# EUROPÄISCHE PATENTSCHRIFT

(11) **EP 1 205 028 B1**
(45) Veröffentlichungstag und Bekanntmachung des Hinweises auf die Patenterteilung: **20.10.2004**
(21) Anmeldenummer: 00962226.7
(22) Anmeldetag: 17.08.2000
(51) Int. Cl.: H03J 7/00

(54) **LADUNGSPUMPE**
LOADING PUMP
POMPE DE CHARGEMENT

(30) Priorität: 18.08.1999 DE 19939104
(43) Veröffentlichungstag der Anmeldung: 15.05.2002
(73) Patentinhaber: Infineon Technologies AG, 81669 München (DE)
(72) Erfinder: GOSSMANN, Timo, D-85579 Neubiberg (DE); KROEBEL, Hans-Eberhard, D-81735 München (DE); SCHOLZ, Markus, D-81737 München (DE)
(74) Vertreter: Epping Hermann & Fischer
(86) Internationale Anmeldenummer: PCT/DE2000/002791
(87) Internationale Veröffentlichungsnummer: WO 2001/013517

(56) Entgegenhaltungen:
- EP-A- 0 798 862
- WO-A-89/01263
- US-A- 5 166 641
- US-A- 5 703 511
- US-A- 5 781 048

## Beschreibung

Die Erfindung betrifft eine Schaltungsanordnung einer Ladungspumpe mit einer Eingangsseite, einer Ausgangsseite und mit mindestens einem Stromspiegel und einem Transistor, welche einem Quellen-Zweig zur Erzeugung eines Quellen-Stromes und einem Senken-Zweig zur Erzeugung eines Senken-Stromes zugeordnet sind, wobei mindestens ' ein Zweig über einen eingangsseitigen Transistor verfügt und die beiden Zweige als Endstufe jeweils zumindest einen ausgangsseitigen Transistor und einen Schaltungstransistor aufweisen, wobei ein erster Zweig über einen Referenzstrom gesteuert wird.

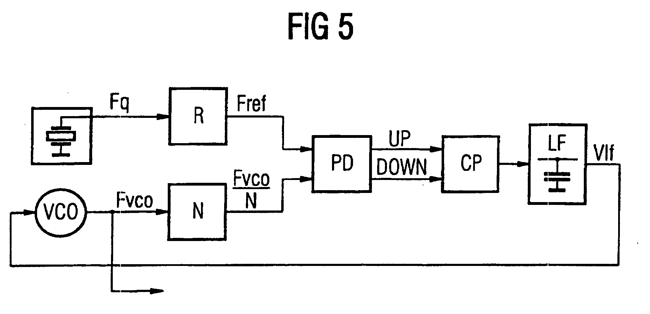

Beim Einsatz einer Phasenregelschleife (PLL=Phase Locked Loop) ist es das Ziel, mit Hilfe einer hochgenauen Referenzfrequenz eine weitere hochgenaue und stabile Frequenz F_{vco} an einem Oszillator VCO zu erzeugen, welche sich gegebenenfalls von der ursprünglichen Referenzfrequenz unterscheiden kann. Eine beispielhafte Schaltung einer solchen PLL ist in der später beschriebenen Figur 5 dargestellt. Dort wird eine meist quarzstabile Frequenz F_{q} mit einem Frequenzteiler R bis auf eine benötigte Referenzfrequenz F_{ref} heruntergeteilt. Gleichzeitig wird die Ausgangsfrequenz F_{vco} des spannungsgesteuerten Oszillators VCO, mit Hilfe eines weiteren Teilers N auf eine Frequenz F_{vco}/N heruntergeteilt. Diese beiden geteilten Frequenzen F_{ref} und F_{vco}/N werden einem Phasen(-Frequenz-)Detektor PD zugeführt, in dem sie bezüglich ihrer relativen Phasenlage, das heißt bezüglich einer sich relativ zueinander ändernden Frequenz, verglichen werden. Der Phasen-Detektor PD erzeugt an seinem Ausgang zwei pulsweitenmodulierte Impulsfolgen UP und DOWN, deren Pulsweiten in einer festen Beziehung zum Phasenunterschied der Frequenzen an seinen Eingängen stehen.

Wenn die Frequenz F_{vco}/N zu hoch gegen F_{ref} ist, also wenn die Phase der Frequenz F_{vco}/N der von F_{ref} voreilt, schaltet der Phasen-Detekor den DOWN-Ausgang gegenüber dem UP-Ausgang länger ein. Das gleiche gilt in umgekehrter Weise, wenn die Phase der Frequenz F_{vco}/N der Frequenz F_{ref} nacheilt, dann schaltet der Phasen-Detektor den UP-Ausgang gegenüber dem DOWN-Ausgang länger ein. Bei einer genau gleichen Phasenlage der beiden Eingangsfrequenzen F_{ref} und F_{VCO}/N in den Phasen-Detektor PD können an die beiden Ausgänge des Phasen-Detektors entweder keine Impulse oder genau gleich lange Impulse auf dem UP- und DOWN-Ausgang abgegeben werden. Bei der Abgabe genau gleich langer Impulse spricht man von einem sogenannten Anti-Backlash-Puls (ABL-Puls). Die Erzeugung dieser Impulse beim Vorliegen einer Phasenidentität ist aus dynamischer Sicht günstiger, als eine Schaltung bei der bei gleicher Phasenlage keiner der beiden Ausgänge eingeschaltet ist.

Die UP- und DOWN-Impulsfolgen steuern eine Ladungspumpe CP an, an deren Ausgang ein Schleifenfilter LF angeschlossen ist, welches wie ein Integrator wirkt. Bei diesem Schleifenfilter LF kann es sich um einen aktiven oder vorzugsweise um einen passiven Filter in der Phasenregelschleife handeln.

Ein Impuls auf der UP-Leitung veranlaßt die Ladungspumpe CP einen Strom einer definierten Größe in das Schleifenfilter LF zu leiten, so daß die Spannung am Schleifenfilter V_{LF} durch die in das Schleifenfilter transportierte Ladungsmenge über die Dauer des UP-Impulses steigt. Dieser Vorgang wird als "Sourcen" bezeichnet und in der Ladungspumpe durch den Quellen-Zweig bewirkt.

Ein Impuls auf der DOWN-Leitung zieht einen Strom aus dem Schleifenfilter LF heraus, so daß die Spannung tendenziell über die Dauer des Impulses fällt. Dieser Vorgang wird als "Sinken" bezeichnet und durch den Senken-Zweig der Ladungspumpe bewirkt.

Die mittlere Spannungsänderung am Schleifenfilter wird also bei gleich großen Strömen ausschließlich von der relativen Dauer der UP- und DOWN-Pulse zueinander bestimmt. Bei genau gleichen Phasen der beiden Eingangsfrequenzen F_{ref} und F_{vco}/N am Phasen-Detektor, das heißt beim Auftreten des Anti-Backlash-Pulses, sollte sich die Spannung am Schleifenfilter LF idealerweise nicht ändern, da der Nettostrom in das Schleifenfilter gleich Null ist und auch keine Nettoladungsmenge in das Schleifenfilter oder vom Schleifenfilter weg transportiert wird.

Die Spannung v_tune am Ausgang V_{lf}, die sich am Schleifenfilter LF einstellt, dient nun als Steuerspannung für den Oszillator VCO, dessen Frequenz F_{VCO} beziehungsweise dessen Phase durch die nun geschlossene Regelschleife an die Phase des Quarzoszillators Q gekoppelt wird. Durch eine Veränderung des Teilerverhältnisses des Teilers N kann die Oszillator-Frequenz F_{vco} in weiten Bereichen eingestellt werden.

Zu beachten ist hierbei allerdings, daß hierzu die Steuerspannung für den Oszillator, die gleich der Spannung v_tune am Ausgang V_{lf} des Schleifenfilters LF ist, in einem weiten Bereich variiert werden muß, um den spannungsgesteuerten Oszillator VCO auf der gewünschten Frequenz halten zu können. Idealerweise heißt dies, daß der genutzte Spannungsbereich bis nahe an das Nullpotential und nahe an die Versorgungsspannung herangehen soll. Dies ist besonders bei portablen Anwendungen wichtig, da dort die Versorgungsspannung durch die zur Verfügung stehenden Akkus im Bereich von 3 Volt liegt. Wichtig ist hierbei auch, daß die Beträge von Quellen- und Senken-Strom gleich groß gehalten werden, da nur dann bei eingerasteter Phasenregelschleife während des ABL-Pulses keine Nettoladung transportiert und der Oszillator VCO nicht verstimmt wird.

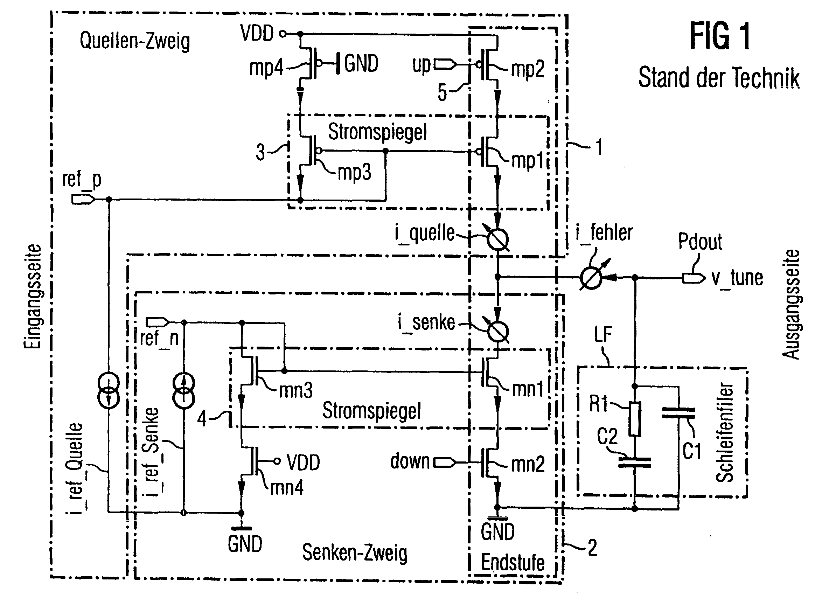

Bei der im Stand der Technik bekannten Schaltungsanordnung einer Ladungspumpe, wie sie beispielhaft in der Figur 1 dargestellt ist, weist diese einen Quellen-Zweig auf, bestehend aus PMOS-Tranistoren mp1, mp2, mp3, mp4, die einen geschalteten Stromspiegel darstellen, der den Strom i_ref_quelle mit einem vorgegebenen Spiegelverhältnis n multipliziert und von der Spannungsversorgung VDD in den Ausgangsanschluß Pdout mit der Spannung v_tune speist, sobald das UP-Steuersignal ein logisches LOW-Potenial aufweist. An den UP-Steuereingang wird das invertierte UP-Signal des Phasen-Detektors PD angelegt.

Weiterhin weist diese bekannte Ladungspumpe einen spiegelbildlich zum Quellen-Zweig angeordneten Senken-Zweig, der entsprechend seiner Funktion mit NMOS-Transistoren mn1, mn2, mn3, mn4 ausgestattet ist, die während eines logischen HIGH-Potentials am DOWN-Steueranschluß den mit dem vorgegebenen Spiegelverhältnis n multiplizierten Strom i_ref_senke aus dem Ausgangsanschluß Pdout in Richtung Masse VSS ableitet.

Bei dieser Schaltungsanordnung tritt das Problem auf, daß die Spiegelverhältnisse im Quellen-Zweig und Senken-Zweig nur bei einer einzigen Spannung v_tune am Ausgang Pdout, einer bestimmten Betriebstemperatur und einer bestimmten Konstellation der technologischen Parameter (zum Beispiel Ausgangswiderstand der Transistoren, Einsatzspannung V_{T} oder Matching) exakt symmetrisch eingestellt werden können. Aufgrund der Kanallängenmodulation der MOS-Transistoren, der technologischen Streuungen (zum Beispiel Matching) und dem Temperaturverhalten der elektronischen Komponenten, kommt es bei allen anderen Spannungen v_tune zu einer Unsymmetrie der Ströme i_quelle und i_senke. So wird zum Beispiel durch den Transistorausgangswiderstand bei einer größer werdenden Spannung v_tune der Betrag des Senken-Stromes größer und der Betrag des Quellen-Stromes kleiner, während mit kleiner werdender Spannung v_tune der Quellen-Strom i_quelle größer und der Senken-Strom i_senke kleiner wird.

Für Werte v_tune in der Nähe von VDD beziehungsweise Gnd werden zudem die Ausgangstranistoren mp1 beziehungsweise mn1 nicht mehr im (tiefen) Sättigungsbereich betrieben, so daß eine merkliche Reduktion des Quellen- beziehungsweise Senken-Stromes die Folge ist.

In der praktischen Ausführung bedeutet dies beispielsweise, daß der Quellen-Strom i_quelle ab Spannungswerten VDD - 0,4V dramatisch zurück geht und bei v_tune=VDD schließlich 0 ist. Gleiches gilt für den Senken-Strom i_senke, der sich ab ca. 0,4V dramatisch verkleinert und schließlich bei der Spannung v_tune=0V ebenfalls Null wird. In der Praxis bedeutet dies, daß ein Fehlerstrom zwischen Quellen- und Senken-Zweig "i_fehler" bei gleichzeitig aktiven Quellen-_und Senken-Teilen erzeugt wird. Dieser Fehlerstrom steigt also an der Ober- und Untergrenze der Versorgungsspannung extrem an und führt bei v_tune=VDD dazu, daß der Fehlerstrom gleich dem Senken-Strom i_senke wird, da der Quellen-Strom i_quelle gleich 0 wird und umgekehrt bei der Spannung v_tune=0 der Fehlerstrom gleich dem Quellen-Strom i_quelle wird, da der Senken-Strom i_senke gleich 0 ist. Dies bedeutet also, daß in Spannungsbereichen v_tune nahe VSS beziehungsweise nahe VDD die Symmetrie der Senken-Ströme der Senken-Seite i_senke und der Quellen-Seite i_quelle stark gestört sind.

Aufgrund dieses Verhaltens der Schaltungsanordnung mit dem oben geschilderten Symmetrieproblem, ist der nutzbare Bereich für die Abstimmspannung v_tune auf einen relativ engen Wertebereich - um einen mittleren Idealwert herum - begrenzt.

Bezüglich der Anwendung der Ladungspumpe in einem PLL-Kreis bedeutet dies, daß der ABL-Puls nur bei einer einzigen Spannung v_tune keinen Fehlerstrom i_fehler in das Schleifenfilter einspeist. Bei allen anderen Spannungen und damit anderen eingestellten Oszillatorfrequenzen F_{vco} kann die Spannung am Schleifenfilter bei jedem PLL-Durchlauf im Mittelwert nur dann konstant gehalten werden, wenn der ABL-Puls verzogen wird, das heißt, entweder der Quellen- oder der Senken-Teil der Pumpe etwas länger eingeschaltet wird. Nur dann kann die in einem Referenzzyklus im Mittelwert auf das Schleifenfilter transportierte Gesamtladung zu Null werden.

Durch den dann allerdings unsymmetrischen ABL-Puls wird der Spannung v_tune am Ausgang Pdout (Loopfilterspannung) ein transienter periodischer Anteil aufmoduliert, der wiederum den Oszillator VCO dazu veranlaßt, neben seiner Sollfrequenz weitere Nebenfrequenzen im Abstand F_{ref} von der Hauptfrequenz zu erzeugen. Diese Nebenfrequenzen (Spurs) sind unerwünscht.

In dem Dokument WO 89/01263 ist ein Phasenregelkreis angegeben, bei dem ein nichtlinearer spannungsgesteuerter Oszillator mittels einer Ladungspumpe angesteuert wird..Die Ladungspumpe hat eine einstellbare Verstärkung. Spiegelbildlich zu einer Ausgangsstufe mit zwei komplementären MOS-Transistoren sind zwei weitere MOS-Transistoren vorgesehen, die in einem Konversionsschaltkreis angeordnet sind. Dieser Konversionsschaltkreis dient dazu, die Gatespannung des n-Kanal-Transistors der Ladungspumpe in eine komplementäre Gatespannung für den p-Kanal-Transistor zu konvertieren.

Die Druckschrift EP0798862 zeigt eine Ladungspumpenschaltung, bei der ein Schaltungsblock zum Auslöschen von Strom-Spikes vorgesehen ist, der zwei komplementäre Transistoren umfaßt.

Es ist Aufgabe der Erfindung, eine Schaltungsanordnung für eine Ladungspumpe zu finden, bei der die Spiegelverhältnisse im Quellen-Zweig und Senken-Zweig, sowohl über einen weiten Bereich der Ausgangsspannung als auch über einen weiten Betriebstemperaturbereich, möglichst symmetrisch ausgebildet sind.

Die Erfinder haben folgendes erkannt:

In der bekannten Schaltungsanordnung werden zur Erzeugung des Quellen- und Senken-Stromes zwei Referenzströme i_ref_quelle und i_ref_senke generiert und der Ladungspumpen-Endstufe zugeführt. Diese Ströme werden über den eingestellten Spiegelfaktor n transformiert, so daß gilt i_quelle = n * i_ref_quelle und i_senke = n * i_ref_senke. Die Symmetrierung der Ausgangsströme mit der Bedingung |i_quelle| = |i_senke| erfolgt hier einerseits über die Referenzströme i_ref_quelle und i_ref_senke und/oder über die Spiegelfaktoren des Quellen-Zweiges mp1 & mp2 zu mp3 & mp4 beziehungsweise des Quellen-Zweiges mn1 & mn2 zu mn3 & mn4. Veränderungen der Eigenschaften der Transistoren durch gegenüber dem Optimum veränderten Betriebsbedingungen können sich hier sehr leicht negativ auf die Symmetrierung auswirken.

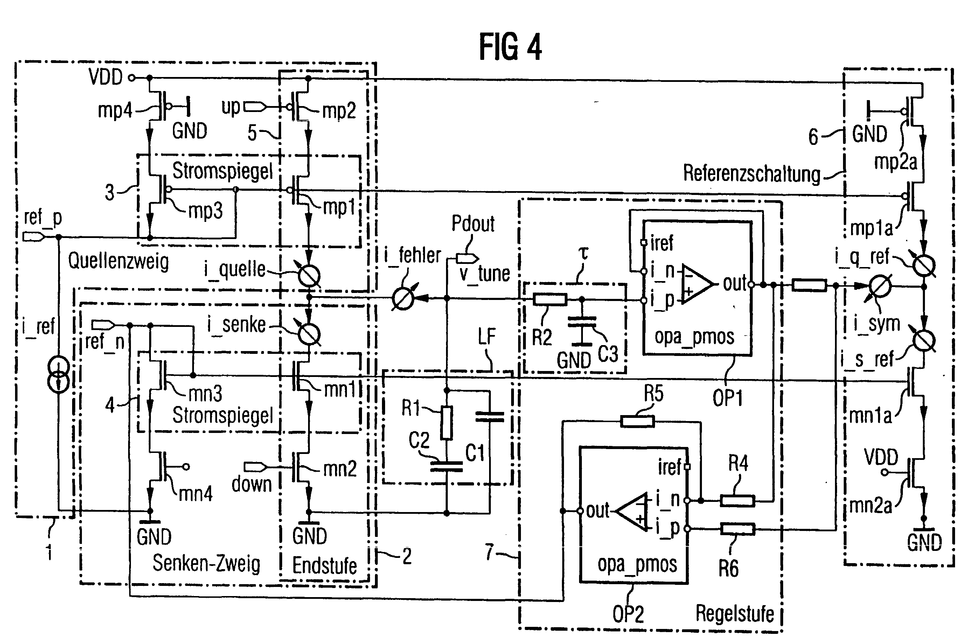

Dieser Unsicherheit der Symmetrie der Referenzströme kann erfindungsgemäß dadurch entgangen werden, daß anstelle von zwei Referenzströmen nur ein einziger Referenzstrom generiert wird, der entweder in den Referenzzweig mp3 & mp4 des Quellen-Zweiges oder in den Referenzzweig mn3 & mn4 des Senken-Zweiges eingespeist wird. Nun kann zusätzlich eine Referenzschaltung hinzugefügt werden, die die Endstufe der Ladungspumpe exakt nachbildet und deren Ausgang mit der Tuningspannung v_tune vom Ausgang der Ladungspumpe Pdout beaufschlagt wird, so daß ein Symmetriestrom i_sym generiert wird, der den Fehlerstrom i_fehler nachbildet. Die Tuningspannung soll dabei möglichst wenig belastet werden, um sie nicht durch die zusätzlichen Maßnahmen zu verfälschen. Der Symmetriestrom i_sym wird dann gemessen. Der nicht am festen Referenzstrom hängende Pumpenteil (Quelle oder Senke) wird so nachgeregelt, daß sich ein Symmetriestrom i_sym von Null ergibt. Die Regelung erfolgt über die Gatespannung des freien Zweiges der Endstufe beziehungsweise der Referenzschaltung. Die in dem den Endstufenzweig nachbildenden Referenzweig ebenfalls enthaltenen Schalttransistoren mn2a und mp2a können in Ausführungsvarianten entweder weggelassen werden, nach innen gelegt werden oder wie beispielsweise in der Figur 4 gezeigt außen eingebaut sein. Ein zu 0 geregelter Symmetriestrom i_sym bewirkt auch einen Fehlerstrom i_fehler von 0, da Endstufe und Referenzschaltung unter gleichen Bedingungen arbeiten.

Es wird also damit das Prinzip der Steuerung beim Stand der Technik durch eine Regelung ersetzt. Die erzielbare Symmetrie ist dann unabhängig von Umgebungseinflüssen und technologischen Schwankungen, um Größenordnungen besser als beim Stand der Technik, und der Aussteuerbereich der Spannung v_tune unter Beibehaltung der Stromsymmetrie wird deutlich erweitert.

Entsprechend diesem Erfindungsgedanken schlagen die Erfinder vor, eine Schaltungsanordnung einer Ladungspumpe mit einer Eingangsseite, einer Ausgangsseite und mit mindestens einem Stromspiegel und einem Transistor, welche einem Quellen-Zweig zur Erzeugung eines Quellen-Stromes und einem Senken-Zweig zur Erzeugung eines Senken-Stromes zugeordnet sind, wobei mindestens ein Zweig über einen eingangsseitigen Transistor verfügt und die beiden Zweige eine Endstufe mit jeweils zumindest einem ausgangsseitigen Transistor und einen Schaltungstransistor aufweisen, wobei ein erster Zweig über einen Referenzstrom gesteuert wird, dahingehend weiterzuentwickeln, daß zusätzlich eine Referenzstufe vorgesehen ist, in welcher die Endstufe der Zweige, zumindest bezüglich der ausgangsseitigen Transistoren, nachgebildet ist und an der Referenzstufe einen dem Fehlerstrom äquivalenten Symetriestrom generiert, welcher ein Mittel zur Regelung des zweiten Zweiges steuert.

Nachbilden bedeutet im Sinne dieser Erfindung entweder eine Kopie, oder eine topologisch gleiche Schaltung mit Transistoren, die alle im Verhältnis zu denen in der Endstufe um den gleichen Faktor vergrößerten oder verkleinerten Tranistorweiten. Hierdurch kann zwischen den Endstufen ein dem Fehlerstrom i_fehler nachgebildeter Symmetriestrom i_sym generiert werden, ohne die Endstufe der Ladungspumpe zu beeinflussen, wobei dieser ein Mittel zur Regelung des zweiten Zweiges steuern kann und damit einen Regelkreis zur Vermeidung von Fehlerströmen aufbaut. Da nun eine Regelung verwirklicht ist, werden auch Temperatureinflüsse und sonstige veränderliche und schädliche Eigenschaften der elektronischen Komponenten der Ladungspumpe, die die Stromsymmetrie beeinflussen, automatisch korrigiert.

Entsprechend dem Erfindungsgedanken, kann das Mittel zur Regelung des zweiten Zweiges mindestens einen Operationsverstärker OP2 aufweisen, an dessen Eingängen eine dem Fehlerstrom proportionale Spannungsdifferenz angelegt wird und dessen Ausgang zur Beeinflussung des zweiten Zweiges dient.

Eine weitere Ausgestaltung der erfindungsgemäßen Schaltungsanordnung sieht vor, daß das Mittel zur Regelung des zweiten Zweiges zusätzlich zur Nachbildung des Fehlerstromes einen Pufferverstärker, vorzugsweise einen als Spannungsfolger geschalteten Operationsverstärker, aufweist. Hierdurch bleibt die Spannung v_tune am Ausgang Pdout weitestgehend unbelastet, wird kopiert und steht der Regelstufe als Hilfsmittel zur Nachbildung des Fehlerstromes i_fehler durch einen Symmetriestrom i_sym zur Verfügung.
Weiterhin kann zwischen der Endstufe und der Referenzschaltung, insbesondere beim Einsatz der Ladungspumpe in einer Phasenregelschleife, ein Schleifenfilter vorgesehen werden.

Gemäß einer weiteren erfindungsgemäßen Fortbildung der Schaltungsanordnung kann vorgesehen werden, daß als Mittel zur Regelung des zweiten Kreises, ein Dämpfungsglied τ am Eingang des Pufferverstärkers oder des als Spannungsfolger geschalteten Operationsverstärkers verwendet wird. Mit diesem Dämpfungsglied τ kann eingestellt werden, wie schnell die Nachregelung des jeweils zweiten Zweiges erfolgt. Erfindungsgemäß kann das Dämpfungsglied τ aus einem Widerstand und einer Kapazität bestehen. Die Zeitkonstante dieses Dämpfungsgliedes sollte dann so eingestellt werden, daß die Regelung schnell genug ist, es aber dennoch nicht zu unerwünschten Schwingneigungen kommt. Das bedeutet, daß bei einem vorhandenen Schleifenfilter diese Zeitkonstante im wesentlichen auf das Schleifenfilter abgestimmt werden muß.

Erfindungsgemäß kann weiterhin der zweite Zweig über einen eingangsseitigen Transistor verfügen, wenn der verwendete Operationsverstärker OP2 einen Stromausgang besitzt. Weiterhin kann die Schaltungsanordnung vorteilhaft dahingehend erweitert werden, daß zumindest ein Schaltungstransistor mn2, mp2 zwischen dem Ausgang der Ladungspumpe und dem ausgangsseitigen Transistor mn1, mp1 angeordnet ist.

Die Anordnung des mindestens einen Schaltungstransistors mn2, mp2 kann auch so erfolgen, daß zumindest ein ausgangsseitiger Transistor mn1, mp1 zwischen dem Ausgang der Ladungspumpe und einem Schaltungstransistor mn2, mp2 angeordnet ist.

Weiterhin wird die Schaltungsanordnung bezüglich ihrer Symmetrieeigenschaften verbessert, wenn mindestens ein, symmetrisch zu einem Schaltungstransistor mn2, mp2 angeordneter, eingangsseitiger Symmetrietransistor mn4, mp4 vorgesehen ist.

Zur Beschleunigung der Schaltungsvorgänge, also insbesondere zur Verwendung der Ladungspumpe für PLL's mit hoher Frequenz, kann zwischen dem Gate zumindest eines Schaltungstransistors mn2, mp2 und dem Gate des ausgangsseitigen Transistors mn1, mp1 des gleichen Zweiges eine Kapazität C_senke, C_quelle geschaltet werden.

Vorteilhaft ist es im übrigen, wenn der Senken-Zweig zum Quellen-Zweig spiegelbildlich aufgebaut ist.

Die verwendeten Transistoren des Quellen-Zweiges können als PMOS-Transistoren und die Transistoren des Senken-Zweiges als NMOS-Transistoren ausgebildet sein.

Außerdem besteht auch die Möglichkeit, die Transistoren des Quellen-Zweiges als p-Jfet und die Transistoren des Senken-Zweiges als n-Jfet auszubilden.

Aufgrund der erfindungsgemäßen Ausgestaltung der Schaltungsanordnung einer Ladungspumpe ergeben sich die folgenden Vorteile:
1. Höchste Symmetrie von Quellen- und Senken-Strom i_quelle, i_senke unabhängig von der anliegenden Spannung v_tune am Ausgang Pdout, unabhängig von den technologischen Schwankungen (z.B. Schwellenspannung, Matching, etc.) und unabhängig von der bestehenden Betriebstemperatur.
2. Ein maximal nutzbarer Bereich der Spannung v_tune bis nahe an die Grenzen der zur Verfügung stehenden Versorgungsspannung.
3. Es ist eine Dimensionierung für optimale dynamische Symmetrie der Ausgangstransistoren möglich, da die NMOS- und PMOS-Transistoren durch die Regelung die gleiche Größe haben können und damit auch gleich große parasitäre Elemente vorliegen.
4. Es wird eine deutliche Verringerung (Halbierung) des schaltungstechnischen Aufwandes bei der Referenzstrom-Erzeugung erreicht, da nur noch ein Referenzstrom i_ref benötigt wird. Es entfällt also auch der gesamte Aufwand der Symmetrierung der im Stand der Technik vorhandenen zwei Referenzströme i_ref_senke und i_ref_quelle:

Gemäß dem Erfindungsgedanken kann die oben dargestellte Ladungspumpe vorzugsweise in einer Phasenregelschleife (PLL=Phase Locked Loop) eingesetzt werden. Eine solche erfindungsgemäße Phasenregelschleife weist einen Regelkreis, bestehend aus mindestens einem Phasendetektor PD zur Bestimmung einer Phasenverschiebung zwischen einer Referenzfrequenz F_{ref} und einer heruntergeteilten Ausgangsfrequenz F_{VCO}/N eines spannungsgesteuerten Oszillators VCO auf, der die Ladungspumpe CP steuert, an die wiederum ein Schleifenfilter LF angeschlossen ist und der Ausgang des Schleifenfilters den spannungsgesteuerten Oszillator VCO steuert.

Weiterhin kann zur Erzeugung der Referenzfrequenz F_{ref} ein Quarzoszillator Q und ein nachgeschalteter Referenzteiler R vorgesehen werden.

Es versteht sich, daß die vorstehend genannten und nachstehend noch zu erläuternden Merkmale der Erfindung nicht nur in der jeweils angegebenen Kombination, sondern auch in anderen Kombinationen oder in Alleinstellung verwendbar sind, ohne den Rahmen der Erfindung zu verlassen.

Weitere Merkmale der Erfindung ergeben sich aus den Unteransprüchen und der nachfolgenden Beschreibung der Ausführungsbeispiele unter Bezugnahme auf die Zeichnungen.

Im folgenden wird die Erfindung anhand der Zeichnungen näher beschrieben:
Figur 1: Ladungspumpe für eine PLL gemäß dem Stand der Technik;
Figur 2: Einfache erfindungsgemäße Schaltungsanordnung einer Ladungspumpe mit einem Pufferverstärker und einen Operationsverstärker;
Figur 3: Einfache erfindungsgemäße Schaltungsanordnung einer Ladungspumpe mit zwei Operationsverstärkern und vertauschten Schaltungstransistoren und ausgangsseitigen Transistoren;
Figur 4: Verbesserte erfindungsgemäße Schaltungsanordnung einer Ladungspumpe mit zwei Operationsverstärkern mit zusätzlichen Symmetrietransistoren;
Figur 5: Beispielhafte Schaltungsanordnung einer PLL mit einer erfindungsgemäßen Ladungspumpe.

Die Figur 1 zeigt eine aus dem Stand der Technik bekannte Ladungspumpe CP mit auf der Eingangsseite liegenden Eingängen i_ref_quelle, i_ref_senke, UP und DOWN und auf der Ausgangsseite liegendem Ausgang der Ladungspumpe Pdout.

Zum besseren Verständnis sind funktionale Bereiche gestrichelt umrandet.

Die Ladungspumpe weist einen Quellen-Zweig 1 und einen spiegelbildlich dazu angeordneten Senken-Zweig 2 auf. In jedem Zweig 1, 2 befinden sich Stromspiegel 3, 4, die jeweils aus einem eingangsseitigen Transistor mp3, mn3 und einem ausgangsseitigen Transitor mp1, mn1 bestehen. Die ausgangsseitigen Transistoren mp1, mn1 werden durch die beiden Schaltungstransistoren mp2, mn2, die mit den UP- beziehungsweise DOWN-Eingängen in Verbindung stehen, geschaltet, so daß entsprechend dem Anliegen der Impulse am UP- beziehungsweise DOWN-Eingang Strom von oder zum Ausgang Pdout fließt, an dem eine Spannung v_tune anliegt. Diese Gruppe der ausgangsseitigen Transistoren mp1, mp2, mn1, mn2 bildet die Endstufe der Ladungspumpe.

Aus Symmetriegründen sind zusätzlich die beiden Symmetrietransistoren mp4 und mn4 vorgesehen. Zusätzlich kann zwischen dem Gate der Schaltungstransistoren mp2 und mn2 und dem Gate des ausgangsseitigen Transistors mp1 und mn1 beziehungsweise dem Eingang i_ref_quelle beziehungsweise i_ref_senke eine Kapazität C_quelle und C_senke geschaltet werden, um die Schaltvorgänge der ausgangsseitigen Transistoren zu beschleunigen. Zur besseren Übersichtlichkeit sind diese Kapazitäten nicht dargestellt. Es wird allerdings darauf hingewiesen, daß derartige Kapazitäten zur Funktionsfähigkeit der Leistungspumpe nicht unbedingt notwendig sind.

Zusätzlich ist am Ausgang der Ladungspumpe noch ein Schleifenfilter LF angeschlossen, das eigentlich schon zu einem PLL-Kreis gezählt werden kann und aus zwei Kapazitäten C1, C2 und einen Widerstand R1 besteht, das den Pumpenausgangsstrom integriert.

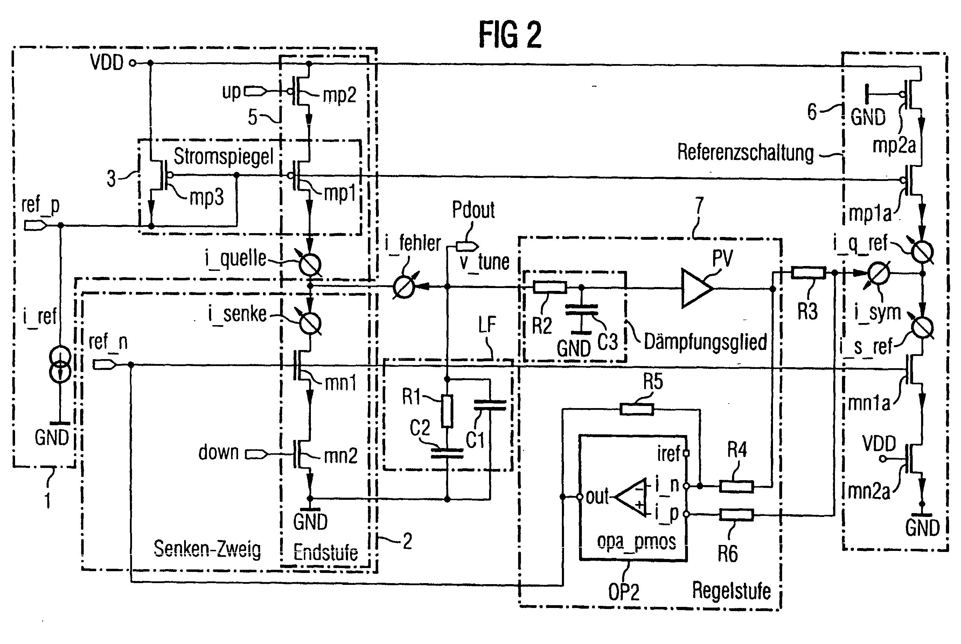

Die Figur 2 zeigt eine einfache erfindungsgemäße Schaltungsanordnung einer Ladungspumpe, in der an Stelle von zwei Referenzströmen nur noch ein einziger Referenzstrom i_ref benötigt wird. Die Ladungspumpe verfügt in ihrer einfachsten Version auch nur über einen einzigen Stromspiegel 3 der auf der Quellen-Seite der Ladungspumpe angeordnet ist. Die Endstufe 5 weist die Schaltungstransistoren mp2 und mn2 auf, die den Strom durch endseitige Transistoren mp1 und mn1 schalten.

Weiterhin ist eine Referenzschaltung 6 aufgebaut, in der die Endstufe 5 wiederholt ist. Das heißt die Transistoren mp1, mp2, mn1 und mn2 werden durch die Transistoren mp1a, mp2a, mn1a und mn2a wiedergegeben, wobei die Gates von mp1a mit mp1 und von mn1a mit mn1 gleichgeschaltet sind, während mp2a und mn2a nicht an die UP- und DOWN-Eingänge angeschlossen sind.

Zwischen der Referenzschaltung 6 und der Endstufe 5 ist eine Regelstufe 7 angeordnet, die über einen Pufferverstärker PV verfügt. Dieser kopiert die Spannung v_tune, ohne die Endstufe zu belasten, über einen Widerstand R3 auf den Ausgang der Referenzschaltung. Dadurch wird in der Referenzschaltung der gleiche Fehlerstrom i_sym erzeugt, wie in der Endstufe. Dieser Symmetriestrom i_sym wird als Spannungsabfall am Widerstand R3 mit Hilfe eines Operationsverstärkers OP2 gemessen. Dessen Ausgangsspannung bildet die Regelspannung für den jeweils zweiten Zweig der Endstufe beziehungsweise Referenzschaltung und stellt sich so ein, daß der Spannungsabfall am Widerstand R3 und damit der Symmetriestrom i_sym gleich 0, also auch der Fehlerstrom i_fehler gleich 0 wird.

Zusätzlich zur Ladungspumpe ist auch noch ein Schleifenfilter LF ausgangsseitig der Ladungspumpe angeschlossen. Dieses Schleifenfilter LF ist zwar beim Einsatz der Ladungspumpe in einer Phasenregelschleife ein sinnvolles Element, jedoch nicht unbedingt für die Erfindung notwendig.

Durch diese Schaltungsanordnung wird über die Regelstufe erreicht, daß über einen weiten Bereich der Spannung v_tune kein Fehlerstrom i_fehler auftritt und damit die bisher bekannten Nebenfrequenzen (Spurs) außerhalb des optimalen Arbeitspunktes reduziert werden.

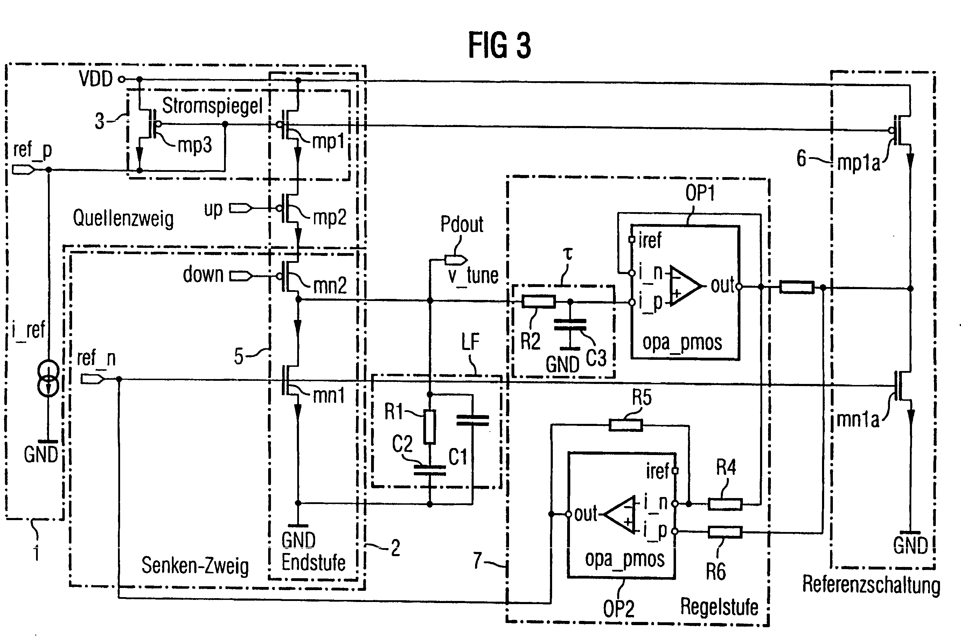

In der Figur 3 ist eine Variation der einfachen Schaltungsanordnung aus der Figur 2 dargestellt, wobei hier in der Endstufe 5 der Ladungspumpe die Schaltungstransistoren mn2 und mp2 mit den ausgangsseitigen Transistoren mn1 und mp1 vertauscht wurden. Entsprechend konnte in der Referenzschaltung 6 auf die Transistoren mp2a und mn2a verzichtet werden.

An Stelle des Pufferverstärkers PV ist nun ein Operationsverstärker OP1 getreten, vor dem ein Dämpfungsglied τ, hier bestehend aus einem Widerstand R2 und einer Kapazität C3, angeordnet ist, mit dem eingestellt werden kann, wie schnell die Nachregelung des Senken-Stromes i_senke erfolgt.

Die Figur 4 zeigt die beste Ausgestaltungsform der Schaltungsanordnung einer erfindungsgemäßen Ladungspumpe mit einer symmetrischen Anordnung der Stromspiegel 3 und 4 im Quellen- und Senken-Zweig mit jeweils einem eingangsseitigen Transistor mn3 und mp3, je einem ausgangsseitigen Transistor mn1 und mpl. Am Sourceeingang (bezogen auf Source, Drain und Gate eines Transistors) des quellen- und ausgangsseitigen Transistor mp1 ist der Schaltungstransistor mp2 angeordnet, dessen Gate-Eingang mit dem UP-Eingang verbunden ist. Ebenso ist am Sourceeingang (bezogen auf Source, Drain und Gate eines Transistors) des senken- und ausgangsseitigen Transistors mn1 der Schaltrungstransistor mn2 angeordnet, dessen Gate-Eingang mit dem DOWN-Eingang verbunden ist. Aus Symmetriegründen sind den Schaltungstransistoren auf der Eingangsseite je ein Symmetrietransistor mn4 und mp4 zugeordnet, die mit Source der eingangsseitigen Transistoren verbunden sind. Der Quellen-Zweig der Schaltung wird über den Referenzstrom i_ref gesteuert. Die eingangsseitigen Transistoren mn3 und mn4 sind dann hilfreich, wenn der Operationsverstärker OP2 einen hochohmigen Stromausgang besitzt, ansonsten können sie weggelassen werden.

Die Endstufe 5, bestehend aus den Transistoren mn1, mn2, mp1 und mp2, ist in einer Referenzschaltung 6 mit den Transistoren mn1a, mn3a, mp1a und mp3a nachgebildet, wobei die Gates der endseitigen Transistoren mp1 und mp1a beziehungsweise mn1 und mn1a miteinander verbunden sind und alle die gleiche relative Größe bezüglich ihren korrespondierenden Transistoren in der Ausgangsstufe haben müssen.

Zwischen dem Ausgang Pdout der Endstufe 5 und dem äquivalenten Ausgang der Referenzschaltung 6 ist ein Pufferverstärker in Form eines Operationsverstärkers OP1 angeordnet, der den Fehlerst:rom i_fehler als Symmetriestrom i_sym kopiert, wobei die Spannung v_tune am Ausgang Pdout möglichst unbelastet bleibt. Zwischen dem Ausgang Pdout der Endstufe 5 und dem Operationsverstärker OP1 ist ein Dämpfungsglied τ, bestehend aus einem, vorzugsweise einstellbaren, Widerstand R2 und einer gegen Masse gelegten Kapazität C3, geschaltet, das die Reaktionsgeschwindigkeit des Regelkreises beeinflußt.

Zwischen dem als Spannungsfolger geschalteten Operationsverstärker OP1 und der Referenzschaltung 6 wird über einen Widerstand R3, der sich durch den Symmetriestrom i_sym ergebende Spannungsabfall abgegriffen und zu einem zweiten Operationsverstärker OP2 geführt. Der Operationsverstärker OP2 regelt aufgrund des gemessenen Symmetriestromes i_sym den Senken-Zweig nun derart nach, daß unabhängig von den gegebenen Betriebstemperaturen, von der anliegenden Ausgangsspannung v_tune und den Eigenschaften von verwendeten elektronischen Komponenten der Symmetriestrom i_sym und damit der Fehlerstrom i_fehler am Ausgang Pdout der Ladungspumpe auf Null gehalten wird.

Durch die, gegenüber den einfachen Varianten der Figuren 2 und 3 nun vorhandenen Transistoren mn3 und mn4 wird nun der Operationsverstärker OP2 in jedem Betriebszustand mit einer Grundlast beaufschlagt, was je nach Typ des verwendeten Operationsverstärkers zu einer stabileren Schaltung führt.
Diese Schaltungsanordnung löst also auf beste Weise die oben geschilderten Symmetrieprobleme der Ladungspumpe im gesamten Aussteuerungsbereich. Das bedeutet, daß nahezu der gesamte Bereich der Versorgungsspannung von 0 bis VDD auch für den Bereich der Spannung v_tune am Ausgang Pdout zur Verfügung steht. In der Praxis bedeutet dies, daß nun lediglich mit einer Reserve von etwa 100mV, gegenüber dem Stand der Technik von etwa 500mV, bei 2,8V Versorgungsspannung VDD gerechnet werden muß.

Beispielhaft ist weiterhin in der Figur 5 eine Phasenregelschleife dargestellt, die eine erfindungsgemäße Ladungspumpe CP aufweist. Die PLL besteht aus einem Phasen-Detektor PD, die zwei Frequenzen F_{ref} und F_{VCO}/N auf eine eventuelle relative Phasenverschiebung hin vergleicht. Die Referenzfrequenz F_{ref} entsteht aus einer quarzstabilisierten Frequenz F_{q}, die ein Quarzoszillator Q erzeugt, einem Referenzteiler R zuführt und wo sie um ein bestimmtes Teilerverhältnis reduziert wird. Die zweite zugeführte Frequenz F_{vco}/N kommt von einem spannungsgeführten Oszillator VCO, die über einen Teiler auf die Frequenz F_{vco}/N heruntergeteilt wird. Der Phasen-Detektor PD erzeugt an seinem Ausgang zwei pulsweitenmodulierte Impulsfolgen UP und DOWN, die bezüglich ihrer Pulsweiten eine feste Beziehung zum Phasenunterschied der beiden Eingangsfreuqenzen F_{ref} und F_{vco}/N aufweisen. Wenn die Frequenz F_{vco}/N höher als die Frequenz F_{ref} ist, beziehungsweise wenn die Frequenz F_{vco}/N zu hoch gegen F_{ref} ist beziehungsweise wenn die Phase der Frequenz F_{vco}/N der Referenzfrequenz F_{ref} voreilt, schaltet der Phasen-Detekor den DOWN-Ausgang gegenüber dem UP-Ausgang länger ein.
Entsprechendes gilt in umgekehrter Weise, bei entsprechend umgekehrten Phaselagen. Bei gleicher Phasenlage, also wenn F_{ref} gleich F_{vco}/N ist, werden an beiden Ausgängen des Phasen-Detektors Anti-Backlash-Pulse (ABL-Pulse) ausgegeben. Die UP- und DOWN-Impulsfolgen steuern die Ladungspumpe CP an, an deren Ausgang das Schleifenfilter angeschlossen ist. Dieses Schleifenfilter wirkt als Integrator. Die Spannung V_{LF} des Schleifenfilters LF dient wiederum als Steuerung des spannungsgesteuerten Oszillators VCO, womit die Regelschleife der PLL geschlossen ist.

## Patentansprüche

1. Schaltungsanordnung einer Ladungspumpe mit einer Eingangsseite, einer Ausgangsseite und mit mindestens einem Stromspiegel (3) und je einem Transistor (mn1, mp1), welche einem Quellen-Zweig (1) zur Erzeugung eines Quellen-Stromes (i_quelle) und einem Senken-Zweig (2) zur Erzeugung eines Senken-Stromes (i_senke) zugeordnet sind, wobei mindestens ein Zweig (1, 2) über einen eingangsseitigen Transistor (mn3, mp3) verfügt und die beiden Zweige (1, 2) eine Endstufe (5) mit jeweils zumindest einem ausgangsseitigen Transistor (mn1, mp1) und einen Schaltungstransistor (mn2, mp2) aufweisen, wobei ein erster Zweig (1) über einen Referenzstrom gesteuert wird,
**dadurch gekennzeichnet,**
**daß** zusätzlich eine Referenzstufe (6) vorgesehen ist, in welcher die Endstufe (5) der Zweige (1, 2), zumindest bezüglich der ausgangsseitigen Transistoren (mn1, mp1), nachgebildet ist und an der Referenzstufe (6) einen einem Fehlerstrom (i_fehler) nachgebildeten äquivalenten Symmetriestrom (i_sym) generiert, welcher ein Mittel (7) zur Regelung des zweiten Zweiges (2) steuert.

2. Schaltungsanordnung gemäß dem voranstehenden Anspruch 1, **dadurch gekennzeichnet, daß** das Mittel (7) zur Regelung des zweiten Zweiges (2) mindestens einen Operationsverstärker (OP2) aufweist, an dessen Eingängen eine dem Symetriestrom (i_sym) und dem Fehlerstrom (i_fehler) p:roportionale Spannung angelegt wird und dessen Ausgang zur Beeinflussung des zweiten Zweiges (2) dient.

3. Schaltungsanordnung gemäß dem voranstehenden Anspruch 2, **dadurch gekennzeichnet, daß** das Mittel (7) zur Regelung des zweiten Zweiges (2) zusätzlich zur Nachbildung des Fehlerstromes (i_fehler) einen Pufferverstärker (PV), vorzugsweise einen als Spannungsfolger geschalteten Operationsverstärker (OP1), aufweist.

4. Schaltungsanordnung gemäß einem der voranstehenden Ansprüche 1 bis 3, **dadurch gekennzeichnet, daß** zwischen der Endstufe (5) und dem Mittel (7) zur Regelung des anderen Zweiges ein Schleifenfilter (LF) vorgesehen ist.

5. Schaltungsanordnung gemäß einem der voranstehenden Ansprüche 1 bis 4, **dadurch gekennzeichnet, daß** das Mittel (7) zur Regelung des zweiten Zweiges weiterhin ein Dämpfungsglied (τ) aufweist.

6. Schaltungsanordnung gemäß einem der voranstehenden Ansprüche 1 bis 5, **dadurch gekennzeichnet, daß** auch der zweite Zweig über einen eingangsseitigen Transistor (mn3, mp3) verfügt.

7. Schaltungsanordnung gemäß einem der voranstehenden Ansprüche 1 bis 6, **dadurch gekennzeichnet, daß** zumindest ein Schaltungstransistor (mn2, mp2) auf der Ausgangsseite angeordnet ist.

8. Schaltungsanordnung gemäß einem der voranstehenden Ansprüche 1 bis 7, **dadurch gekennzeichnet, daß** zumindest ein Schaltungstransistor (mn2, mp2) zwischen dem Ausgang der Ladungspumpe und dem ausgangsseitigen Transistor (mn1, mp1) angeordnet ist.

9. Schaltungsanordnung gemäß einem der voranstehenden Ansprüche 1 bis 8, **dadurch gekennzeichnet, daß** zumindest ein ausgangsseitiger Transistor (mn1, mp1) zwischen dem Ausgang der Ladungspumpe und einem Schaltungstransistor (mn2, mp2) angeordnet ist.

10. Schaltungsanordnung gemäß einem der voranstehenden Ansprüche 1 bis 9, **dadurch gekennzeichnet, daß** mindestens ein, symmetrisch zu einem Schaltungstransistor (mn2, mp2) angeordneter, eingangsseitiger Symmetrietransistor (mn4, mp4) vorgesehen ist.

11. Schaltungsanordnung gemäß einem der voranstehenden Ansprüche 1 bis 10, **dadurch gekennzeichnet, daß** zwischen dem Gate zumindest eines Schaltungstransistors (mn2, mp2) und dem Gate des ausgangsseitigen Transistors (mn1, mp1) des gleichen Zweiges eine Kapazität (C_senke, C_quelle) geschaltet ist.

12. Schaltungsanordnung gemäß einem der voranstehenden Ansprüche 1 bis 11, **dadurch gekennzeichnet, daß** der Senken-Zweig (2) zum Quellen-Zweig (1) spiegelbildlich aufgebaut ist.

13. Schaltungsanordnung gemäß einem der voranstehenden Ansprüche 1 bis 12, **dadurch gekennzeichnet, daß** die Transistoren des Quellen-Zweiges (1) als PMOS-Transistoren und die Transistoren des Senken-Zweiges (2) als NMOS-Transistoren ausgebildet sind.

14. Schaltungsanordnung gemäß einem der voranstehenden Ansprüche 1 bis 12, **dadurch gekennzeichnet, daß** die Transistoren des Quellen-Zweiges (1) als p-Jfet und die Transistoren des Senken-Zweiges (2) als n-Jfet ausgebildet sind.

15. Phasenregelschleife (PLL=Phase Locked Loop) mit einer Ladungspumpe, **dadurch gekennzeichnet, daß** die Ladungspumpe die Merkmales eines der Ansprüche 1 bis 14 aufweist.

16. Phasenregelschleife gemäß dem vorstehenden Anspruch 15, **dadurch gekennzeichnet, daß** diese mit einem Regelkreis bestehend aus mindestens einem Phasendetektor (PD) zur Bestimmung einer Phasenverschiebung zwischen einer Referenzfrequenz F_{ref} und einer Ausgangsfrequenz F_{VCO} eines spannungsgesteuerten Oszillators (VCO) der die Ladungspumpe (CP) steuert, an die wiederum ein Schleifenfilter (LF) angeschlossen ist, dessen Ausgang den spannungsgesteuerten Oszillator (VCO) steuert.

17. Phasenregelschleife gemäß einem der vorstehenden Ansprüche 15 bis 16, **dadurch gekennzeichnet, daß** zur Erzeugung der Referenzfrequenz F_{ref} ein Quarzoszillator (Q) und nachgeschalteter Referenzteiler (R) vorgesehen ist.

## Claims

1. Circuit arrangement for a charge pump having an input side, an output side and having at least one current mirror (3) and a respective transistor (mn1, mp1) which are associated with a source path (1) for producing a source current (i_source) and with a sink path (2) for producing a sink current (i_sink), where at least one path (1,2) has an input-side transistor (mn3, mp3) and both paths (1, 2) have an output stage (5), each containing at least one output-side transistor (mn1, mp1) and a circuit transistor (mn2, mp2), with a first path (1) being controlled via a reference current, **characterized in that** a reference stage (6) is additionally provided in which the output stage (5) of the paths (1, 2) is simulated, at least in terms of the output-side transistors (mn1, mp1), and generates on a reference stage (6) an equivalent symmetrical current (i_sym) which replicates a fault current (i_fault) and controls a means (7) for regulating the second path (2).

2. Circuit arrangement according to the preceding Claim 1, **characterized in that** the means (7) for regulating the second path (2) has at least one operational amplifier (OP2), to whose inputs a voltage proportional to the symmetrical current (i_sym) and to the fault current (i_fault) is applied and whose output is used to influence the second path (2).

3. Circuit arrangement according to the preceding Claim 2, **characterized in that** the means (7) for regulating the second path (2) additionally has a buffer amplifier (PV), preferably an operational amplifier (OP1) connected as a voltage follower, for simulating the fault current (i_fault).

4. Circuit arrangement according to one of the preceding Claims 1 to 3, **characterized in that** a loop filter (LF) is provided between the output stage (5) and the means (7) for regulating the other path.

5. Circuit arrangement according to one of the preceding Claims 1 to 4, **characterized in that** the means (7) for regulating the second path also has an attenuation element (τ).

6. Circuit arrangement according to one of the preceding Claims 1 to 5, **characterized in that** the second path also has an input-side transistor (mn3, mp3).

7. Circuit arrangement according to one of the preceding Claims 1 to 6, **characterized in that** at least one circuit transistor (mn2, mp2) is arranged on the output side.

8. Circuit arrangement according to one of the preceding Claims 1 to 7, **characterized in that** at least one circuit transistor (mn2, mp2) is arranged between the output of the charge pump and the output-side transistor (mn1, mp1).

9. Circuit arrangement according to one of the preceding Claims 1 to 8, **characterized in that** at least one output-side transistor (mn1, mp1) is arranged between the output of the charge pump and a circuit transistor (mn2, mp2).

10. Circuit arrangement according to one of the preceding Claims 1 to 9, **characterized in that** at least one input-side symmetrical transistor (mn4, mp4) arranged symmetrically with respect to a circuit transistor (mn2, mp2) is provided.

11. Circuit arrangement according to one of the preceding Claims 1 to 10, **characterized in that** a capacitor (C_sink, C_source) is connected between the gate of at least one circuit transistor (mn2, mp2) and the gate of the output-side transistor (mn1, mp1) in the same path.

12. Circuit arrangement according to one of the preceding Claims 1 to 11, **characterized in that** the sink path (2) is of mirror-inverted design with respect to the source path (1).

13. Circuit arrangement according to one of the preceding Claims 1 to 12, **characterized in that** the transistors in the source path (1) are in the form of PMOS transistors, and the transistors in the sink path (2) are in the form of NMOS transistors.

14. Circuit arrangement according to one of the preceding Claims 1 to 12, **characterized in that** the transistors in the source path (1) are in the form of p-Jfets, and the transistors in the sink path (2) are in the form of n-Jfets.

15. Phase locked loop (PLL) having a charge pump, **characterized in that** the charge pump has the features of one of Claims 1 to 14.

16. Phase locked loop according to the preceding Claim 15, **characterized in that** it [lacuna] with a control loop comprising at least one phase detector (PD) for determining a phase shift between a reference frequency F_{ref} and an output frequency F_{vco} from a voltage controlled oscillator (VCO) which controls the charge pump (CP), to which, in turn, a loop filter (LF) is connected whose output controls the voltage controlled oscillator (VCO).

17. Phase locked loop according to one of the preceding Claims 15 to 16, **characterized in that** a crystal oscillator (Q) and a downstream reference divider (R) are provided in order to produce the reference frequency F_{ref}.

## Revendications

1. Circuit d'une pompe à charge comprenant un côté d'entrée, un côté de sortie et au moins un miroir (3) de courant et respectivement un transistor (mn1, mp1), qui est associé à une branche (1) de source de production d'un courant (i_quelle) de source et d'une branche (2) de puit de production d'un courant (i_senke) de puit, au moins une branche (1, 2) disposant d'un transistor (mn3, mp3) du côté de l'entrée et les deux branches (1, 2) ayant un étage (5) d'extrémité ayant respectivement au moins un transistor (mn1, mp1) du côté de la sortie et un transistor (mn2, mp2) de circuit, une première branche (1) étant commandée par un courant de référence,
**caractérisé**
**en ce qu'**il est prévu en plus un étage (6) de référence dans lequel l'étage (5) d'extrémité des branches (1, 2) est reproduit au rnoins pour ce qui concerne les transistors (mn1, mp1) du côté de la sortie et produit sur l'étage (6) de référence un courant (i_sym) de symétrie équivalent reproduisant un courant (i_fehler) de défaut qui commande un moyen (7) de régulation de la deuxième branche (2).

2. Circuit suivant la revendication 1 précédente, **caractérisé en ce que** le moyen (7) de régulation de la deuxième branche (2) comporte au moins un amplificateur (OP2) opérationnel aux entrées duquel est appliquée une tension proportionnelle au courant (i_sym) de symétrie et au courant (i_fehler) de défaut et dont la sortie sert à influer sur la deuxième branche (2).

3. Circuit suivant la revendication 2 précédente, **caractérisé en ce que** le moyen (7) de régulation de la deuxième branche (2) comprend en outre, pour la reproduction du courant (i_fehler) de défaut, un amplificateur (PV) tampon, de préférence un amplificateur (OP1) opérationnel monté en suiveur de tension.

4. Circuit suivant l'une des revendications 1 à 3 précédentes, **caractérisé en ce qu'**il est prévu, entre l'étage (5) d'extrémité et le moyen (7) de régulation de l'autre branche, un filtre (LF) à boucle.

5. Circuit suivant l'une des revendications 1 à 4 précédentes, **caractérisé en ce que** le moyen (7) de régulation de la deuxième branche comporte, en outre, un élément (τ) d'amortissement.

6. circuit suivant l'une des revendications 1 à 5 précédentes, **caractérisé en ce que** la deuxième branche aussi dispose d'un transistor (mn3, mp3).

7. Circuit suivant l'une des revendications 1 à 6 précédentes, **caractérisé en ce qu'**au moins un transistor (mn2, mp2) de circuit est disposé du côté de la sortie.

8. Circuit suivant l'une des revendications 1 à 7 précédentes, **caractérisé en ce qu'**au moins un transistor (mn2, mp2) de circuit est disposé entre la sortie de la pompe à charge et le transistor (mn1, mp1) du côté de la sortie.

9. Circuit suivant l'une des revendications 1 à 8 précédentes, **caractérisé en ce qu'**au moins un transistor (mn1, mp1) du côté de la sortie est disposé entre la sortie de la pompe à charge et un transistor (mn2, mp2) de circuit.

10. Circuit suivant l'une des revendications 1 à 9 précédentes, **caractérisé en ce qu'**il est prévu au moins un transistor (mn4, mp4) de symétrie du côté de l'entrée, disposé symétriquement par rapport à un transistor (mn2, mp2) de circuit.

11. Circuit suivant l'une des revendications 1 à 10 précédentes, **caractérisé en qu**'il est monté entre la grille d'au moins un transistor (mn2, mp2) de circuit et la grille du transistor (mn1, mp1) du côté de la sortie de la même branche une capacité (C_senke, C_quelle).

12. Circuit suivant l'une des revendications 1 à 11 précédentes, **caractérisé en ce que** la branche (2) de puit est constituée d'une manière symétrique comme en un miroir de la branche (1) de source.

13. Circuit suivant l'une des revendications 1 à 12 précédentes, **caractérisé en ce que** les transistors de la branche (1) de source sont constitués sous la forme de transistors PMOS et les transistors de la branche (2) de puit sous la forme de transistors NMOS.

14. Circuit suivant l'une des revendications 1 à 12 précédentes, **caractérisé en ce que** les transistors de la branche (1) de source sont constitués sous la forme de Jfet du type p et les transistors de la branche (2) de puit sont constitués sous la forme de Jfet du type n.

15. Boucle à verrouillage de phase (PLL=Phase Locked Loop) comprenant une pompe à charge, **caractérisé en ce que** la pompe à charge a les caractéristiques de l'une des revendications 1 à 14 précédentes.

16. Boucle à verrouillage de phase suivant la revendication 15 précédente, **caractérisée en ce qu'**elle commande, par un circuit de régulation constitué d'au moins un détecteur (PD) de phase destiné à déterminer un déphasage entre une fréquence F_{ref} de référence et une fréquence F_{vco} de sortie d'un oscillateur (VCO) commandé en tension, qui commande la pompe (CP) à charge à laquelle est raccordé à nouveau un filtre (LF) à boucle, dont la sortie commande l'oscillateur (VCO) commandé en tension.

17. Boucle à verrouillage de phase suivant l'une des revendications 15 à 16 précédentes, **caractérisée en ce qu'**il est prévu, pour la production de la fréquence F_{ref} de référence, un oscillateur (Q) à quartz et un diviseur (R) de référence monté en aval.
